Europäisches Patentamt

European Patent Office

Office européen des brevets

(19)

(11) Publication number: **0 405 850 A2**

## (12) EUROPEAN PATENT APPLICATION

(21) Application number: **90306835.1**

(22) Date of filing: **22.06.90**

(51) Int. Cl.5: **H01L 21/31**, H01L 21/312, H01L 21/90

(30) Priority: **30.06.89 US 374504**

(43) Date of publication of application:
**02.01.91 Bulletin 91/01**

(84) Designated Contracting States:
**DE ES FR GB IT**

(71) Applicant: **AMERICAN TELEPHONE AND TELEGRAPH COMPANY**
**550 Madison Avenue**
**New York, NY 10022(US)**

(72) Inventor: **Harrus, Alain Simon**
**205 E. Meade Street**
**Philadelphia, Pennsylvania 19118(US)**
Inventor: **Hills, Graham William**
**1101 Flexer Avenue**
**Allentown, Pennsylvania 18103(US)**
Inventor: **Thoma, Morgan Jones**
**359 Village Walk Drive**
**Macungie, Pennsylvania 18062(US)**

(74) Representative: **Johnston, Kenneth Graham et al**
**AT&T (UK) LTD. AT&T Intellectual Property Division 5 Mornington Roadoadoad**
**Woodford Green Essex, IG8 OTU(GB)**

(54) Dielectric formation process and devices produced thereby.

(57) The occurrence of low-density regions in conformal layers deposited between raised topographic features (for example, metal runners) on an integrated circuit is prevented or reduced by the inventive process. The low-density regions (termed "soft oxides" when the conformal layer is an oxide of silicon), are preferentially attacked by subsequent etching procedures and produce undesired trenches which interfere with subsequent processing. The inventive process forms spacers, or fillets, between the raised topographic features. Then a conformal layer, such as dielectric formed from TEOS, may be deposited without causing the formation of low-density regions.

EP 0 405 850 A2

## DIELECTRIC FORMATION PROCESS AND DEVICES PRODUCED THEREBY

### Background of the Invention

This invention relates to semiconductor integrated circuits and methods for manufacturing them.

As semiconductor integrated circuits have become increasingly complex, there has arisen a need for multiple levels of conductive interconnections between individual transistors. The conductive interconnections are typically made from a metal, such as tungsten or aluminum, but they may be made from other materials, for example, polysilicon or silicides. As transistor geometries shrink and greater numbers of transistors are included on each chip, the distances between adjacent conductors also shrink.

In a typical manufacturing process, transistors are formed in a substrate. The transistors are typically covered with a dielectric. Windows are opened to active regions of the transistors and filled with conductive material. Then conductive intereconnections are formed upon the dielectric.

To form conductive interconnections in a typical manufacturing process, a layer of conductive material is deposited upon a dielectric substrate. The layer of conductive material is then patterned to form conductive interconnections, or conductors, which may connect portions of individual transistors. Next, another dielectric (often termed an interlevel dielectric) is deposited to cover the conductors. The interlevel dielectric serves to encapsulate and protect the conductors, while providing an outer surface upon which additional conductors may be formed.

A typical interlevel dielectric material is silicon dioxide ($SiO_2$). Silicon dioxide is often deposited for use as an interlevel dielectric via a chemical vapor deposition (CVD) process from a variety of source gases. (Deposition techniques may be performed at atmospheric, or low pressure, and may also be plasma enhanced, if desired.) When silicon dioxide is deposited over and between closely spaced conductors, various problems can arise. For example, when silicon dioxide is deposited in a conventional CVD process using silane as a source gas between closely spaced conductors (or other topographic features), a step coverage problem is manifested. Silane-based silicon dioxide is not conformal and has a tendency to form voids in the spaces between the conductors (or other topographic features). Consequently, those practitioners who employ silane-based silicon dioxide as an interlevel dielectric have usually been forced to use a repeated deposit and etch-back procedure which helps to eliminate the void problem.

An example of a repeated deposit and etchback procedure is provided by Kaanta et al., "Submicron Wiring Technology with Tungsten and Planarization", IEEE International Electron Devices (IEDM), ppg. 209--212, 1987. The Kaanta et al. publication describes the formation of an interlevel dielectric deposited from silane. However, the article explains that, because the dielectric is not sufficiently conformal, the deposition must be broken into several steps, and an argon sputter etching procedure must be performed between each step.

U.S. Patent No. 4,481,070 issued to Thomas et al. is another example of the repetitious deposition and etch-back techniques employed to prevent the formation of voids in the space between adjacent metal runners when a non-conformal dielectric is used.

The repeated deposit and etchback procedure consumes time and money. Furthermore, the repeated deposit and etch-back procedure may not solve the void problem completely. A subsequent application of, for example, spin-on glass is often necessary to more completely fill or eliminate the void.

Recent advances in semiconductor technology have yielded a class of organometallic precursors for silicon dioxide which produce a dielectric with rather conformal properties. (Conformal coverage is coverage which reproduces the underlying topography.) Some examples of these organometallic precursors are tetraethoxysilane ($Si(OC_2H_5)_4$), with the acronym, "TEOS"; tetramethoxysilane ($Si(OCH)_4$), with the acronym, "TMOS"; diacetoxyditertiarybutoxysilane ($C_{10}H_{26}O_4Si$), with the acronym, "DADBS"; and, tetramethylcyclotetrasiloxane ($C_4H_{16}Si_4O_4$), with the acronym, "TMCTS", sold under the trademark, "TOMCATS" by J. C. Schumacher, a unit of Air Products and Chemicals, Inc..

Among those skilled in the art, the expression, "depositing a layer of TEOS", for example, is generally understood to mean the deposition of a dielectric layer by decomposition of TEOS in a reactor. Similar expressions are used, for example, to describe processes utilizing DADBS, TMCTS, etc.

The highly conformal properties of the resulting dielectric (which is an oxide of silicon) produced as a result of the decomposition of the aforementioned organometallics makes it possible to deposit a thick layer of dielectric with significantly less risk of void formation between closely spaced topographic features, such as conductors. Consequently, organometallic precursors have become increasingly popular in processes for forming interlevel dielectrics because of their conformal properties. In general, the highly conformal deposition properties of dielectrics produced from organometallic precursors have made them apparently ideal candidates for interlevel dielectrics which can be thickly deposited in one step with a decreased risk of void formation. When organometallics are used, generally, there is no repeated deposit and etchback procedure required to eliminate voids which form between two closely spaced conductors or other topographic features.

## Summary of the Invention

Applicants have discovered that highly conformal layers as used in the prior art exhibit a hitherto unrecognized disadvantage. In particular, when a highly conformal dielectric (for example, a silicon oxide deposited from an organometallic precursor) is deposited to fill the space between two closely spaced conductors (or other topographic features), the resulting apparently solid dielectric layer often exhibits a low-density region (sometimes termed a "soft oxide" region when silicon dioxide is the dielectric) in the space between the conductors (or other topographic features). Subsequent etch-back procedures and wet cleaning procedures (which are commonly used in the integrated circuit industry) may preferentially attack the low-density region and create an undesirable groove between the conductors or other topographic features.

The formation of the undesirable low-density region can be reduced or eliminated by applicants' invention. According to the invention, before a final conformal layer is deposited, fillets or spacers are formed on the sides of the conductors (or other topographic features). The spacers are formed by depositing a preliminary layer and anisotropically etching the preliminary layer to form a spacer. The spacers destroy the comparatively vertical profile of the sides of the conductors (or other topographic features). The spacers provide a smooth sloping contour to the sides of the conductors or other topographic features. Next, a comparatively thick final layer of a conformal material is deposited above the conductors or topographic features and in the space between the topographic features and spacers. The spacers permit filling of the space between the topographic features, while preventing the formation of the undesired low-density region.

## Brief Description of the Drawing

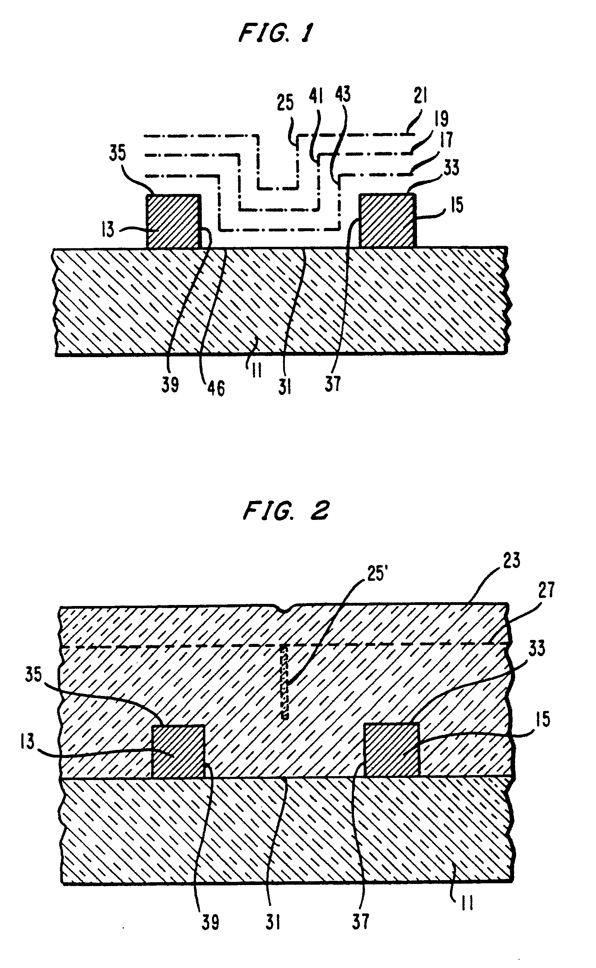

Figs. 1-7 are cross-sectional views which schematically illustrate the present invention.

## Detailed Description

In Fig. 1, reference numeral 11 denotes a substrate which may be, for example, silicon, epitaxial silicon, or silicon dioxide. Topographic features denoted by reference numerals 13 and 15 may be, for example, conductive runners. The conductive runners may be made from metal such as aluminum or tungsten, or from polysilicon or silicide or polycide. Each feature, 13 and 15, has a sidewall denoted by reference numerals 39 and 37, respectively, and a top surface denoted by reference numerals 35 and 33, respectively. Sidewalls 37 and 39 are generally perpendicular to substrate 11. Sidewalls 37 and 39, together with upper surface 31 of substrate 11 define a space 46 between features 13 and 15.

Fig. 1 illustrates what happens when a conformal layer is deposited over features 13 and 15 and in the aforementioned space 46. Although the chemical vapor deposition processes used to deposit oxides of silicon are one-step processes, phantom layers 17, 19, and 21 provide successive snapshot or "stop-action views" during successive stages of the deposition of a conformal layer. It will be noted that space 43 is associated with phantom layer 17; space 41 is associated with phantom layer 19; and, space 25 is associated with phantom layer 21. Examining phantom layers 17, 19, and 21, in sequence, one sees that, as the deposition process proceeds, a layer of uniform thickness is deposited on the sidewalls 39 and 37 and along the surface 31 of substrate 11. However, it will be noted that the aspect ratio of spaces 43, 41 and, ultimately, 25 becomes progressively larger. (The aspect ratio is defined as the height of the space divided by its width.) The layers on the sides 39 and 37 are growing toward each other more rapidly than the layer contacting surface 31 of substrate 11 is growing upward. In other words, the space between features 13 and 15 fills or closes more rapidly from the sides than from the bottom.

Although conformal layers are generally considered to have advantageous properties in the semiconductor art, especially in the filling of spaces between raised features, such as 13 and 14, Fig. 1 illustrates a hitherto unrealized disadvantage of conformal layers. The conformal filling process creates a space with a dynamic (e.g. changing) aspect ratio. As the aspect ratio of spaces 43, 41 and 25 becomes progressively larger (and spaces 43, 41, and 25 become increasingly smaller), it becomes increasingly difficult to fill each space. The precise mechanism responsible for the formation of the low-density region has not been determined. If the deposition process is performed without plasma enhancement, the primary deposition mechanism is surface migration of the reactant species. It is believed that it becomes increasingly difficult to fill spaces, such as space 25, because reactants do not migrate along the sides as readily as they do in a larger space. The addition of plasma enhancement to the deposition process provides other deposition mechanisms, but does not eliminate the low-density region. For example, the plasma provides ions which enhance the surface migration process and may also enhance surface adhesion. However, applicants' investigations show that a low- density region still manifests itself, even with plasma-enhanced deposition processes. Consequently, although the final layer may appear closed or solid, it contains a low density region or "soft oxide" which may contain unreacted organometallic material or byproducts.

The final result of the filling process is shown in Fig. 2. In Fig. 2, reference numerals 23 denotes the completed conformal layer. Reference numerals 25′ denotes a low-density region or "soft oxide", which is formed by the closure of space 25 shown in Fig. 1. It will be noted, from an examination of Fig. 2, that after soft oxide region 25′ is formed, the dielectric is deposited relatively uniformly above imaginary reference line 27 (which demarcates the top of low-density region 25′).

According to conventional semiconductor industry practice, after the structure depicted in Fig. 2 is completed, an etch-back procedure is used to reduce the thickness of dielectric 23. An anisotropic etch-back procedure uniformly reduces the thickness of layer 23 toward substrate 11. However, as can be seen from Fig. 2, after dielectric 23 is etched downward past imaginary reference line 27, which touches the top of low-density region 25′, the low-density region area 25′ will be encountered. The anisotropic etching procedure (together with subsequent wet cleaning procedures) will preferentially attack soft oxide area 25′, creating a groove in dielectric 23. In particular, applicants have found that a wet cleaning procedure used to remove sodium residue after anisotropic etching exhibits great preference for the low-density region. (The wet cleaning procedure uses either an 8:1 ratio of ethylene glycol and buffered HF if aluminum runners are exposed, or a 100:1 ratio of water and HF if no aluminum is exposed.)

The groove created by the preferential etching of low density area 25′ is undesirable because it damages the smooth upper topography of the resulting surface and makes subsequent metal deposition difficult. It is known to those skilled in the art that further anisotropic etching transfers or moves the void downward toward surface 31 as the etching proceeds. Thus, Figs. 1 and 2 illustrate that the use of a conformal layer creates an apparently solid dielectric, which may exhibit an unexpected groove during subsequent etching.

Before the details of applicants' invention are presented, some further discussion of the properties of conformal materials and the problems associated with their deposition will be discussed:

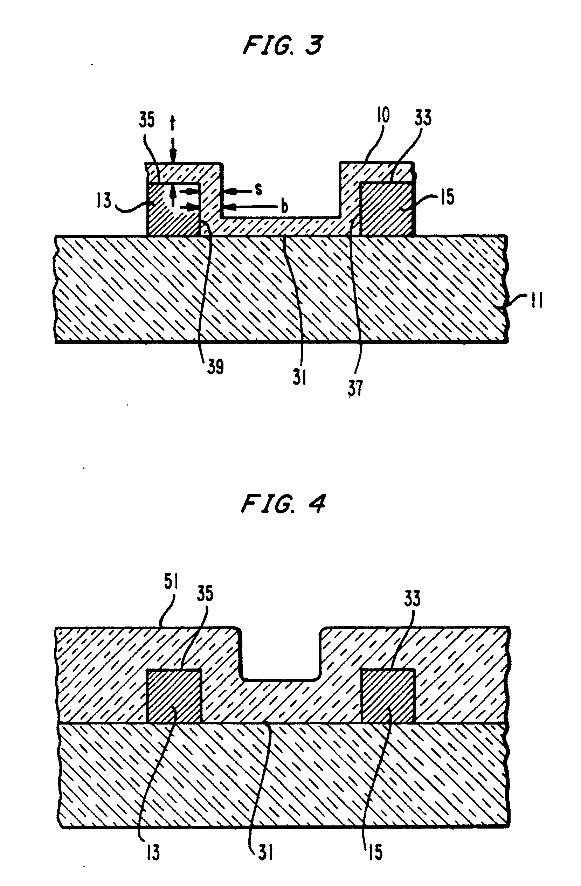

Conformality is often described by various ratios. Referring to Fig. 3, the conformality of layer 10 may be conveniently described by the ratio $\frac{t}{s}$, where t is the thickness of layer 18 above top surface 35 of feature 13, and s is the thickness of the same layer 10 measured outward from sidewall 39 of feature 13 at a point near the top of feature 13. Another measure of conformality is the ratio, $\frac{b}{s}$, where b is the thickness of layer 10 measured at a point near the bottom sidewall 39.

Dielectric layers deposited from the various organometallic precursors mentioned before exhibit varying degrees of conformality, as measured by the above-mentioned ratios. For example, plasma-enhanced TEOS-based dielectrics have an $\frac{t}{s}$ ratio of roughly 0.5 to 0.6, while the same ratio for plasma-enhanced DADBS is roughly 0.7 to 0.8, and for TMCTS is roughly 0.5 to 0.6. It is not essential to the practice of this invention that the $\frac{t}{s}$ ratio be high, i.e., near 1. The $\frac{t}{s}$ ratio governs the minimum thickness of dielectric (measured, for example, upward from surface 35), which must be deposited to assure filling the space between features 13 and 15 (since the space, as noted before, fills from the sides). The ratio, $\frac{b}{s}$, is more important to the successful practice of this invention. The ratio, $\frac{b}{s}$ should be as close to 1 as possible. All of the aforementioned organometallics exhibit a satisfactory $\frac{b}{s}$ ratio (with typical values of roughly greater than, or equal to, 0.9 in plasma-enhanced deposition. If the $\frac{b}{s}$ ratio is much less than 1.0, the layer 10 assumes a re-entrant shape and, consequently, fabrication of fillets or spacers with the convex profile, which will aid in the practice if the invention becomes difficult.

The low-density region, such as that illustrated by reference numeral 25′ in Fig. 2, is not the same as a void. A void is the absence of any material. A low-density region is generally solid, although probably of non-stoichiometric composition.

As mentioned before, each organometallic precursor for silicon oxide has a fairly characteristic $\frac{b}{s}$ ratio. For a particular precursor material, the initial aspect ratio of the space to be filled is important in determining whether a void is formed or a low-density region is formed. If the initial aspect ratio is high and the material's conformality (as measured by the $\frac{b}{s}$ ratio) is relatively low, there is a likelihood that voids will form as the space is filled. Fillets, or spacers, have been previously employed in an effort to eliminate such voids. However, if the aspect ratio is lower, or if the material's conformality (as measured by the $\frac{b}{s}$ ratio) is high, the likelihood of void formation is reduced, but the likelihood of low-density region formation increases. It has already been mentioned, in connection with Fig. 2, that after the low-density region has formed, further deposition of the dielectric proceeds to cover, and thus hide, the low-density region.

The existence of the low-density region comes as a surprise to practitioners who subsequently etch away the outer portion of seemingly "solid" or voidless dielectrics. After the outer portion of the dielectric has been etched and removed, the etchant encounters the low-density region and preferentially attacks it. The low-density region is etched away significantly faster than the surrounding dielectric. A groove then appears where the low-density region had been. The groove appears in an area which heretofore had been believed solid, or of uniform density. The problem is further aggravated because of the anisotropic etching procedure used. The anisotropic process transfers the groove downward toward the conductors or topographic features which have been covered. The result is that a groove appears between the conductors or topographic features.

The mechanism just described is frustrating to the process engineer who chooses a highly conformal material to avoid intrinsic void formation, only to find that the apparently solid conformal material suddenly exhibits a groove during subsequent processing.

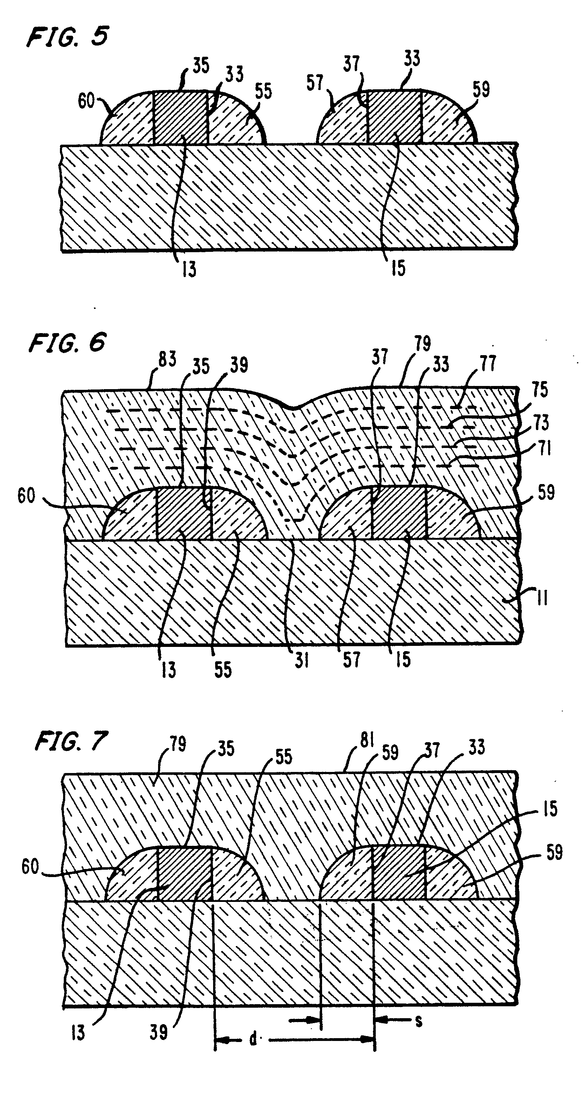

Figs. 4-6 illustrate applicant's inventive process for eliminating the low-density area $25'$. Figs. 4 and 5 illustrate the spacer-forming process, while Figs. 6 and 7 illustrate the subsequent filling of the space between features 13 and 15.

Turning to Fig. 4, the spacers are formed by first depositing a layer 51 over the tops 35 and 33 of features 13 and 15, respectively. It will be noted that layer 51 also fills in the space defined by sidewalls 37 and 39, together with upper surface 31 of substrate 11. Layer 51 should not be deposited so thickly that a low-density region, such as $25'$ in Fig. 2, is formed.

Generally, layer 51 may be made from a conformal material, such as one of the aforementioned organometallics. However, if the initial aspect ratio of the space defined by sidewalls 37 and 39 together with the upper surface 31 of substrate 11 is not too severe, a non-conformal layer (e.g., formed from silane) may be used to form the spacers. If features 13 and 15 are aluminum runners, the deposition process may be plasma enhanced so that the deposition temperature may be kept low enough to avoid damage to the aluminum. It is also possible to use silicon nitride to form the spacers.

After layer 51 has been deposited, it is etched-back by anisotropic etching procedures well known to those skilled in the art to produce spacers 57, 55, 59 and 60 illustrated in Fig. 5. (If layer 51 had been deposited as thick as illustrated in Fig. 2, it would not be possible to form spacers because the anisotropic etching process generally transfers the contour of the upper surface downward.) If desired, the etching procedure need not be carried out completely and upper surface 31 of substrate 11, together with tops 33 and 35 of features 15 and 13, respectively, may be covered with a thin layer of conformal layer 51.

An exemplary process suitable for the anisotropic etching of layer 51 is by reactive ion etching with $CHF_3$ and $O_2$ at 60 sccm and 7 sccm, respectively, at 1400 watts power and 65 millitorr pressure, in an hexode reactor. Other methods will occur to those skilled in the art. The above etching process, when used upon TEOS layers, produces spacers with cross-sections somewhat resembling quarter (i.e., 1/4) circles. The quarter circle spacers perform nicely in the practice of this invention, although both spacers with somewhat steeper or flatter profiles will also work. (If a non-conformal material is used to form the spacers, a steeper profile will obtain.)

Turning now to Fig. 6, a conformal layer 79 is deposited over features 13 and 15. Phantom layers 71, 73, 75 and 77 show successive steps or "stop-action views" in the continuous deposition of conformal layer 79.

It will be noted, from an examination of Fig. 6, that the dynamic aspect ratio problem illustrated in Fig. 1 is no longer present in Fig. 5, and that the space between features 13 and 15 fills without the formation of a soft oxide area, such as that denoted by reference $25'$ or 53. The effects of steep sidewalls (i.e., 37 and 39), which, in Fig. 1, caused the deposition process to proceed more rapidly from the sides than from the bottom, have been eliminated by spacers 55 and 57. The spacers permit filling in a pattern which is not conducive to low-density region formation.

Fig. 7 illustrates the structure of Fig. 5 after a standard etch-back procedure has been applied. The etch-back procedure thins conformal layer 79, yielding outer surface 81. The same anisotropic reactive ion etching procedure described above may be utilized, although other procedures known to those skilled in the art may be used.

Although spacers have been employed in various applications before, their use with a conformal material is unexpected and counterintuitive because practitioners have generally believed that conformal materials tend to deposit in generally void-free layers; and, hence, there has been no apparent need for spacers with conformal materials.

In one illustrative embodiment of the present invention, features 13 and 15 are aluminum first-level metal runners. The runners are approximately 5000Å high and have steep sides. In some instances, the distance between adjacent runners may be roughly one micron (denoted by dimension "d" in Fig. 7). The spacers have a base width of approximately 3000Å each (denoted by dimension "s" in Fig. 7). The spacers have been formed by depositing TEOS in a plasma-enhanced deposition chamber with an initial thickness of 6000Å and etching it back to 4000Å as well as permitting a thickness of approximately 2000Å to cover surfaces 31, 35 and 33. Next, a thermal plasma enhanced TEOS deposition is performed to an initial thickness of 25,0000Å. Finally, the second TEOS layer is etched back to a final thickness of 8000Å.

## Claims

**1.** A method of semiconductor integrated circuit fabrication comprising:
fortming a plurality of raised topographic features upon a substrate, said topographic features having sidewalls, and with each adjacent pair of features defining a space therebetween; depositing a first layer over said features;
AND CHARACTERIZED BY the further steps of etching said first layer to form spacers adjacent to said sidewalls;
depositing a second layer having conformal properties, said second layer contacting said spacers and filling said space.

**2.** The method of claim 1 further including the step of anisotropically etching back said second layer.

**3.** The method of claim 1 wherein said second layer is deposited by decomposition of a material chosen from the group consisting of TEOS, TMOS, DADBS, and TMCTS.

**4.** The method of claim 1 wherein said first layer is deposited by decomposition of a material chosen from the group consisting of TEOS, TMOS, DADBS, and TMCTS.

**5.** The method of claim 1 wherein said raised topographic features are conductors.

**6.** The method of claim 5 wherein said conductors are made from materials chosen from the group consisting of aluminum, aluminum-silicon mixtures, tungsten, polysilicon, and silicides.

**7.** The method of claim 1 wherein
said raised topographic features are runners each of said runners having a sidewall and a top and wherein
said first layer is formed by depositing TEOS in a plasma; and wherein
said etching step is an anisotropic etching step which forms spacers with curved sides and permits a portion of said first TEOS layer to remain on the said tops of said runners and upon said substrate; and wherein

said second layer is formed by depositing TEOS in a plasma over said spacers and over said remaining portion of said first layer of TEOS which is upon said tops of said runners and upon said substrate; and further wherein
said second layer is anisotropically etched, the tops of said runners remaining covered.

FIG. 1

FIG. 2

## FIG. 3

## FIG. 4

FIG. 5

FIG. 6

FIG. 7